# EUROPEAN PATENT APPLICATION

(11) **EP 4 492 072 A1**
(43) Date of publication of application: **15.01.2025**
(21) Application number: 23185038.9
(22) Date of filing: 12.07.2023
(51) Int. Cl.: G01R 31/3842, G01R 31/389, G01R 31/396, H01M 10/48, H02J 7/00, G01R 31/36

(54) **BATTERY CURRENT ESTIMATION**

(71) Applicant: VOLVO TRUCK CORPORATION, 405 08 Göteborg (SE)
(72) Inventor: LIDSTRÖM, Emil, 423 56 TORSLANDA (SE)
(74) Representative: Ström & Gulliksson AB

(57) **Abstract**

A computer system (100) comprising processing circuitry (110) is presented. The processing circuitry (110) is configured to obtain resistance data of a plurality of inter-cell connectors (230) of a battery pack (200) comprising a plurality of battery cells (210a, 210b, 210c, 210d), and obtain inter-cell voltage drops across the plurality of inter-cell connectors (230). The processing circuitry (110) is further configured to determine inter-cell currents based on the resistance data and associated inter-cell voltage drops; and determine a battery pack current estimate of a battery pack current of the battery pack (200) based on the inter-cell currents.

## Description

### TECHNICAL FIELD

The disclosure relates generally to power control. In particular aspects, the disclosure relates to battery current estimation. The disclosure can be applied marine vessels, industrial applications and vehicles, specifically heavy-duty vehicles, such as trucks, buses, and construction equipment, among other vehicle types. Although the disclosure may be described with respect to a particular vehicle, the disclosure is not restricted to any particular vehicle.

### BACKGROUND

Any battery power system or device will generally benefit from estimating a current provided by the battery. The current from the battery (or to the battery during charging) will, in addition to providing an indication of a power consumption of the system or device, further indicate any potential problems indicted by an unexpectedly high or low current.

Generally, in electrically propelled vehicles, current sensors are provided to monitor and detect current going into the traction battery and currents provided by the traction battery. In response to detection of abnormal currents, it is not uncommon for computer systems of the vehicle to be configured to (temporarily) prevent current transfer to/from the battery. To this end, high integrity and reliability in current measurement is important. The high integrity and reliability is advantageous in order to e.g. not damage battery cells by charging with too high currents due to incorrect current reading, or not to erroneously detect too high currents causing an unwanted stop of the usage of the batteries.

### SUMMARY

According to a first aspect of the disclosure, a computer system comprising processing circuitry is presented. The processing circuitry is configured to obtain resistance data of a plurality of inter-cell connectors of a battery pack comprising a plurality of battery cells and obtain inter-cell voltage drops across the plurality of inter-cell connectors. The processing circuitry is further configured to determine inter-cell currents based on the resistance data and associated inter-cell voltage drops, and determine a battery pack current estimate of a battery pack current of the battery pack based on the inter-cell currents.. The first aspect of the disclosure may seek to increase the accuracy, integrity and/or reliability of current measurements provided by a current sensor of a battery pack. A technical benefit may include reduced risk of erroneous measurements of currents, cheaper battery pack as the current sensor may be omitted. A technical benefit may include that basing the estimate on a plurality a currents cause the estimate to converge to a normal distribution by the central limiting theorem.

Optionally in some examples, including in at least one preferred example, the processing circuitry is further configured to determine an inter-cell current average as a mean of the inter-cell currents, and determine the battery pack current estimate based on the inter-cell current average. A technical benefit may include averaging a plurality a currents causing their mean to converge to the true mean of the current by the central limiting theorem and law of large numbers.

Optionally in some examples, including in at least one preferred example, the processing circuitry is further configured to determine an inter-cell current estimate standard deviation as a standard deviation of the inter-cell current average and, for each inter-cell connector exhibiting an inter-cell current being outside a predefined confidence interval of the inter-cell current average, determine that the inter-cell connector is malfunctioning. A technical benefit may include detecting that there is a potential issue with an inter-cell connector, or a sensor associated with that inter-cell connector.

Optionally in some examples, including in at least one preferred example, the processing circuitry is further configured to obtain, from a battery pack current sensor, a battery pack current of the battery pack current and determine a delta current indicator by comparison of the battery pack current and the battery pack current estimate. The processing circuitry is further configured to, responsive to the delta current indicator being outside a permissible error range, determining that the battery pack current sensor is malfunctioning. A technical benefit may include detecting that there is a problem with the battery pack current sensor.

Optionally in some examples, including in at least one preferred example, the processing circuitry is further configured to determine a delta current shift by comparison of the delta current indicator with one or more previous delta current indicators, and responsive to the delta current shift being outside a permissible deviation range, determining that the battery pack current sensor is malfunctioning. A technical benefit may include detecting that there is a problem with the battery pack current sensor.

Optionally in some examples, including in at least one preferred example, the processing circuitry is further configured to, responsive to determining that the battery pack current sensor is malfunctioning, determine that further transfer of power to/from the battery pack is allowed based on the battery pack current estimate. A technical benefit may include allowing the battery back to continue to provide power to a load regardless of the malfunctioning battery pack current sensor as accurate current estimations are provided by the battery pack current estimate.

Optionally in some examples, including in at least one preferred example, the processing circuitry is further configured to update the resistance data of one or more of the plurality of inter-cell connectors based on the battery pack current estimate and inter-cell voltage drops across the plurality of inter-cell connectors. A technical benefit may include ensuring that the resistance data is correct and compensate for ageing, wear etc. of the inter-cell connectors.

Optionally in some examples, including in at least one preferred example, the processing circuitry is further configured to update the resistance data of one or more of the plurality of inter-cell connectors based on time series data of inter-cell voltage drops across the plurality of inter-cell connectors. A technical benefit may include ensuring that the resistance data is correct and compensate for ageing, wear etc. of the inter-cell connectors.

Optionally in some examples, including in at least one preferred example, the processing circuitry is further configured to update the resistance data of one or more of the plurality of inter-cell connectors based on a battery pack current obtained from a battery pack current sensor of the battery pack. A technical benefit may include ensuring that the resistance data is correct and compensate for ageing, wear etc. of the inter-cell connectors.

Optionally in some examples, including in at least one preferred example, the processing circuitry is further configured to determine an inter-cell current average as a mean of the inter-cell currents, and determine the battery pack current estimate based on the inter-cell current average; determine an inter-cell current estimate standard deviation as a standard deviation of the inter-cell current average, for each inter-cell connector exhibiting an inter-cell current being outside a predefined confidence interval of the inter-cell current average, determine that the inter-cell connector is malfunctioning; obtain, from a battery pack current sensor, a battery pack current of the battery pack current, determine a delta current indicator by comparison of the battery pack current and the battery pack current estimate, and responsive to the delta current indicator being outside a permissible error range, determining that the battery pack current sensor is malfunctioning; responsive to determining that the battery pack current sensor is malfunctioning, determine that further transfer of power to/from the battery pack is allowed based on the battery pack current estimate; and update the resistance data of one or more of the plurality of inter-cell connectors based on the battery pack current estimate and inter-cell voltage drops across the plurality of inter-cell connectors, and/or time series data of inter-cell voltage drops across the plurality of inter-cell connectors. A technical benefit may include ensuring that the resistance data is correct and compensate for ageing, wear etc. of the inter-cell connectors. A technical benefit may include allowing the battery back to continue to provide power to a load regardless of the malfunctioning battery pack current sensor as accurate current estimations are provided by the battery pack current estimate. A technical benefit may include detecting that there is a problem with the battery pack current sensor. A technical benefit may include detecting that there is a potential issue with an inter-cell connector, or a sensor associated with that inter-cell connector. A technical benefit may include averaging a plurality a currents causing their mean to converge to the true mean of the current by the central limiting theorem and law of large numbers.

According to a second aspect of the disclosure, a vehicle is presented. The vehicle comprises an electric propulsion source, a battery pack operatively connected to the computer system of the first aspect and configured to provide power to the electric propulsion source. A technical benefit may include reduced risk of erroneous measurements of currents, cheaper battery pack as the current sensor may be omitted. A technical benefit may include that basing the estimate on a plurality a currents cause the estimate to converge to a normal distribution by the central limiting theorem.

Optionally in some examples, including in at least one preferred example, the vehicle is a heavy-duty vehicle.

According to a third aspect of the disclosure, a computer implemented method is presented. The method comprises obtaining, by a processing circuitry of a computer system, resistance data of a plurality of inter-cell connectors of a battery pack comprising a plurality of battery cells, and obtaining, by the processing circuitry of the computer system, inter-cell voltage drops across the plurality of inter-cell connectors. The method further comprises determining, by the processing circuitry of the computer system, inter-cell currents based on the resistance data and associated inter-cell voltage drops, and determining, by the processing circuitry of the computer system, a battery pack current estimate of a battery pack current of the battery pack based on the inter-cell currents.

Optionally in some examples, including in at least one preferred example, the method further comprises determining, by the processing circuitry of the computer system, an inter-cell current average as a mean of the inter-cell currents, and determining, by the processing circuitry of the computer system, the battery pack current estimate based on the inter-cell current average. A technical benefit may include averaging a plurality a currents causing their mean to converge to the true mean of the current by the central limiting theorem and law of large numbers.

Optionally in some examples, including in at least one preferred example, the method further comprises determining, by the processing circuitry of the computer system, an inter-cell current estimate standard deviation as a standard deviation of the inter-cell current average, and for each inter-cell connector exhibiting an inter-cell current being outside a predefined confidence interval of the inter-cell current average, determining, by the processing circuitry of the computer system, that the inter-cell connector is malfunctioning. A technical benefit may include detecting that there is a potential issue with an inter-cell connector, or a sensor associated with that inter-cell connector.

Optionally in some examples, including in at least one preferred example, the method further comprises obtaining, by the processing circuitry of the computer system, from a battery pack current sensor, a battery pack current of the battery pack current, and determining, by the processing circuitry of the computer system, a delta current indicator by comparison of the battery pack current and the battery pack current estimate. The method further comprises responsive to the delta current indicator being outside a permissible error range, determining, by the processing circuitry of the computer system, that the battery pack current sensor is malfunctioning. A technical benefit may include detecting that there is a problem with the battery pack current sensor.

Optionally in some examples, including in at least one preferred example, the method further comprises determining, by the processing circuitry of the computer system, a delta current shift by comparison of the delta current indicator with one or more previous delta current indicators, and responsive to the delta current shift being outside a permissible deviation range, determining, by the processing circuitry of the computer system, that the battery pack current sensor is malfunctioning. A technical benefit may include detecting that there is a problem with the battery pack current sensor.

Optionally in some examples, including in at least one preferred example, the method further comprises, responsive to determining that the battery pack current sensor is malfunctioning, determining, by the processing circuitry of the computer system, that further transfer of power to/from the battery pack is allowed based on the battery pack current estimate. A technical benefit may include allowing the battery back to continue to provide power to a load regardless of the malfunctioning battery pack current sensor as accurate current estimations are provided by the battery pack current estimate.

Optionally in some examples, including in at least one preferred example, the method further comprises, updating, by the processing circuitry of the computer system, the resistance data of one or more of the plurality of inter-cell connectors based on the battery pack current estimate and inter-cell voltage drops across the plurality of inter-cell connectors, and/or time series data of inter-cell voltage drops across the plurality of inter-cell connectors. A technical benefit may include ensuring that the resistance data is correct and compensate for ageing, wear etc. of the inter-cell connectors.

Optionally in some examples, including in at least one preferred example, the method further comprises, updating, by the processing circuitry of the computer system, the resistance data based on the battery pack current. A technical benefit may include ensuring that the resistance data is correct and compensate for ageing, wear etc. of the inter-cell connectors.

According to a fourth aspect of the disclosure, a computer program product is presented. The computer program product comprises program code for performing, when executed by a processing circuitry, the method of the third aspect.

According to a fifth aspect of the disclosure, a non-transitory computer-readable storage medium comprising instructions, which when executed by a processing circuitry, cause the processing circuitry to perform the method of the third aspect.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1A** is an exemplary side view of a vehicle according to an example.
**FIG. 1B** is an exemplary block view of a vehicle according to an example.
**FIG. 2** is an exemplary block view of a battery pack according to an example.
**FIG. 3** is an exemplary block view of a battery pack according to an example.
**FIG. 4** is an exemplary system diagram of a battery pack current estimator according to an example.
**FIG. 5A** is an exemplary block view of a battery pack according to an example.
**FIG. 5B** is an exemplary circuit schematic of a battery pack according to an example.
**FIG. 6** is an exemplary diagram of a method for estimating a current from a battery pack according to an example.
**FIG. 7** is an exemplary block diagram of a computer program product.
**FIG. 8** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

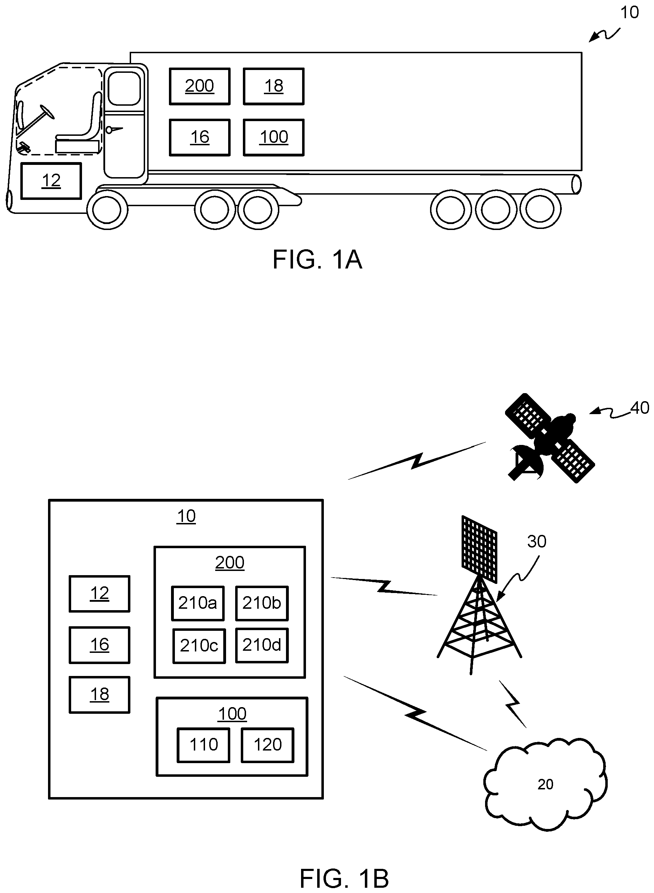

**FIG. 1A** is an exemplary schematic side view of a heavy-duty vehicle **10** (hereinafter referred to vehicle **10** for reasons of brevity). This particular vehicle **10** comprises a tractor unit **10a** which is arranged to tow a trailer unit **10b.** In other examples, other heavy-duty vehicles may be employed, e.g., trucks, buses, and construction equipment. Although not explicitly visualized in **FIG. 1A****,** the skilled person will appreciate that the vehicle **10** comprises all necessary vehicle units and associated functionality such that it may operate as the skilled person would expect of a vehicle **10,** such as a powertrain, chassis, and various control systems. Emphasis in the present disclosure is rather directed at electrical currents of the vehicle **10,** and therefore functionality and features related this will be the focus of the present disclosure. However, the vehicle **10** comprises one or more propulsion sources **12.** The propulsion source **12** may be any suitable propulsion source **12** exemplified by, but not limited to, one or more or a combination of an electrical motor, a combustion engine such as a diesel, gas or gasoline powered engine. At least one propulsion source **12** is an electrical motor. The vehicle **10** further comprises at least one energy source **200** suitable for providing energy for the propulsion source(s) **12.** That is to say, as at least one propulsion source **12** is an electrical motor, at least one propulsion source **12** is a battery pack **200.** The vehicle **10** further comprises sensor circuitry **16** arranged to detect, measure, sense or otherwise obtain data relevant for operation of the vehicle **10.** The data relevant for operation of the vehicle **10** may be exemplified by, but not limited to, one or more of a voltage of the battery pack **200,** a current provided by the battery pack **200,** a speed of the vehicle **10,** a weight of the vehicle **10,** an inclination of the vehicle **10,** a status (state of charge, fuel level etc.) of the energy source **200** of the vehicle **10** etc. Advantageously, the vehicle **10** further comprises communications circuitry **18** configured for communication with, to the vehicle **10,** external devices. The vehicle **10** further comprises a computer system **100.**

As shown in **FIG. 1B****,** the vehicle **10** may communicate with a cloud server **20** using the communications circuitry **18.** The communications circuitry **18** may be configured to communicate with the cloud server **20** directly, or via a communications interface such as a cellular communications interface exemplified by a radio base station **30** in **FIG. 1B****.** The cloud server **20** may be any suitable cloud server exemplified by, but not limited to, Amazon Web Services (AWS), Microsoft Azure, Google Cloud Platform (GCP), IBM Cloud, Oracle Cloud Infrastructure (OCI), DigitalOcean, Vultr, Linode, Alibaba Cloud, Rackspace etc. The communications interface is advantageously a wireless communications interface exemplified by, but not limited to, Wi-Fi, Bluetooth, Zigbee, Z-Wave, LoRa, Sigfox, 2G (GSM, CDMA), 3G (UMTS, CDMA2000), 4G (LTE), 5G (NR) etc. The vehicle **10** may further, via the communications circuitry **18,** be operatively connected to a Global Navigation Satellite System (GNSS) **40** exemplified by, but not limited to, global positioning system (GPS), Globalnaya Navigatsionnaya Sputnikovaya Sistema (GLONASS), Galileo, BeiDou Navigation Satellite System, Navigation with Indian Constellation (NavIC) etc. The vehicle **10** may be configured to utilize data obtain from the GNSS **40** to determine a geographical location of the vehicle **10.**

The computer system **100** of the vehicle **10** is advantageously operatively connected to the communications circuitry **18,** the sensor circuitry **16,** the energy source **200** and/or the propulsion source **12** of the vehicle **10.** The computer system **100** comprises processing circuitry **110.** The computer system **100** may comprise a storage device **120,** advantageously a non-volatile storage device such as a hard disk drives (HDDs), solid-state drives (SSDs) etc. In some examples, the storage device **120** is operatively connected to the computer system **100.**

As mentioned, a vehicle **10** according to the present disclosure is an, at least partly, electrically propelled vehicle. To this end, the vehicle **10** of the present disclosure comprises at least one energy source **200** in the form of an electrical energy source **200,** i.e. at least one battery pack **200.** The vehicle battery pack **200** comprises at least two battery cells **210a, 210b, 210c, 210d.** In **FIG. 1B****,** the battery pack **200** is shown comprising four battery cells **210a, 210b, 210c, 210d.** However, this is for illustrative purposes, and the battery pack **200** may comprise any number of battery cells **210a, 210b, 210c, 210d.** The battery cells **210a, 210b, 210c, 210d.** The battery pack **200** is advantageously configured to provide energy at least to the propulsion source **12** of the vehicle **10.** Additionally, or alternatively, the battery pack **200** may be configured to provide energy to other part components of the vehicle **10** such as, but not limited to, vehicle electronics, climate control of the vehicle **10,** safety functions of the vehicle etc.

Regardless of the load, it may be advantageous to, as previously indicated, accurately estimate a current provided by the battery pack **200** to the load. Accurate current data assists in assessing a health and performance of the battery pack **200.** By monitoring a current to/from the battery pack **200,** charging and discharging patterns may be tracked, abnormal behaviors may be identified, and potential issues like overcharging, undercharging, or excessive discharge (short circuit) may be detected. Accurate current measurements enables evaluation of a battery state of charge and state of health of the battery pack **200,** ensuring optimal performance and extending battery life. Battery packs **200,** when used as traction batteries, generally store a significant amount of energy which increases a risk that abnormal behaviors may lead to hazardous conditions, such as overheating, thermal runaway, or electrical failures. Further to this, accurate current measurements aid in optimizing an energy efficiency of the vehicle **10.** By monitoring a current during charging and/or discharging, an efficiency of a battery pack **200** may be evaluated and opportunities for improvement may be identified. The above notwithstanding, current measurements provide valuable data for performance analysis and diagnostics. By analyzing current profiles during various driving conditions and operations, it is possible to gain insights into energy usage, power demand, efficiency, etc. of the vehicle **10.** This information may assist in diagnosing performance issues, optimizing system configurations, and/or identifying areas for improvement in terms of energy consumption and overall vehicle performance. Further, accurate current measurements are generally required for compliance with regulatory standards and industry guidelines. Many standards and regulations set specific limits on battery current for safety and operational reasons. By accurately measuring and documenting the current, it is possible to demonstrate compliance with these standards and ensure the vehicle **10** meets the necessary requirements.

The inventor behind the present disclosure have identified the importance of current measurements. By inventive thinking and challenging of the technical prejudice of the present technical field, devised an alternative method and system for estimating current to/from a battery pack **200.** The teachings of the present disclosure may be utilized to ensure accuracy of a prior art battery pack current sensor, to replace a prior art battery pack current sensor, to calibrate a prior art battery pack current sensor etc. The importance of the current measurements in batteries causes the skilled person to stay with known prior art battery pack current sensors and provide redundancy by adding further current sensors rather than thinking outside the box and implementing the teachings of the present disclosure.

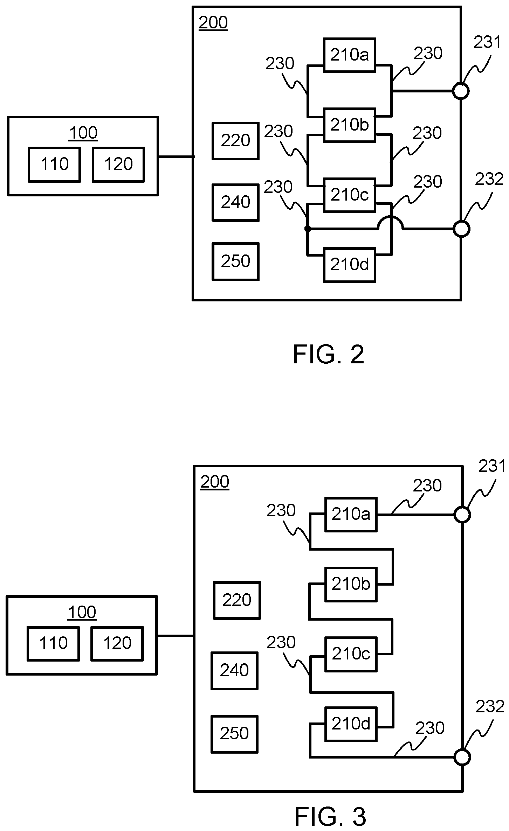

With reference to **FIG. 2** and **FIG. 3****,** battery packs **200** according to some examples will be explained. The battery pack **200** comprises, as previously indicated, at least two battery cells **210a, 210b, 210c, 210d.** In **FIG. 2****,** the battery pack **200** is shown comprising four battery cells **210a, 210b, 210c, 210d.** The battery cells **210a, 210b, 210c, 210d** are connected by inter-cell connectors **230.** The inter-cell connectors **230** are electrically conducting members exemplified by, but not limited to, one or more or combination of busbars, interconnect cables, cell-to-cell weldings, screws etc. The battery pack **200** advantageously comprise a battery pack processing circuitry **220.** The battery pack processing circuitry **220** may for part of the computer system **100** and the processing circuitry **110** of the computer system **100.** The battery pack processing circuitry **220** is configured to monitor operation of the battery pack **200.** To this end, the battery pack processing circuitry **220** is operatively connected to (or comprises) one or more battery pack sensor circuitry **240.** The battery pack sensor circuitry **240** may be configured to measure, sense or otherwise obtain operational data of the battery pack **200.** The operational data of the battery pack **200** may comprise one or more voltages of the battery pack **200,** one or more currents of the battery pack **200,** one or more temperatures of the battery pack **200** etc. Generally, a resistance of the inter-cell connectors **230** is determined/calibrated during manufacturing and/or during design of the battery pack **200.** The resistance of the inter-cell connectors **230** is advantageously stored in non-volatile storage circuitry (not shown in **FIG. 2** or **FIG. 3****)** accessible by the computer system **100.** The battery pack **200** further comprises two or more connectors **231, 232** operatively connected to the battery cells **210a, 210b, 210c, 210d.** Generally, a first connector **231** is operatively connected to a first voltage potential of the battery cells **210a, 210b, 210c, 210d** and a second connector **232** is operatively connected to a second voltage potential of the battery cells **210a, 210b, 210c, 210d.** The battery pack **200** further comprises a battery pack current sensor **250** configured to detect, measure or otherwise obtain a current provided to or by the two or more connectors **231, 232.**

The inter-cell connectors **230** may be configured to connect the battery cells **210a, 210b, 210c, 210d** in series, in parallel or a combination of series or parallel connections. The configuration of the inter-cell connectors **230** will depend on a number of battery cells **210a, 210b, 210c, 210d,** a capacity of the battery cells **210a, 210b, 210c, 210d,** a voltage of the battery cells **210a, 210b, 210c, 210d** and a wanted voltage of the battery pack **200.** The inter-cell connectors **230** connect the battery cells **210a, 210b, 210c, 210d** in order to provide a rated capacity from the battery pack **200** and a rated voltage difference between the first potential (a voltage of the first connector **231)** and the second potential (a voltage of the second connector **232)** of the battery pack **200.** In some examples, a rated voltage of the energy source is approximately 800 V.

In **FIG. 2** the inter-cell connectors **230** are configured to connect the battery cells **210a, 210b, 210c, 210d** in parallel. In **FIG. 3****,** the inter-cell connectors **230** are configured to connect the battery cells **210a, 210b, 210c, 210d** in series.

The battery packs **200** shown in **FIG. 2** and **FIG. 3** are simplified block diagrams. The skilled person will appreciate that the battery packs **200** advantageously comprise further features such as pre-charge circuitry, fuses etc.

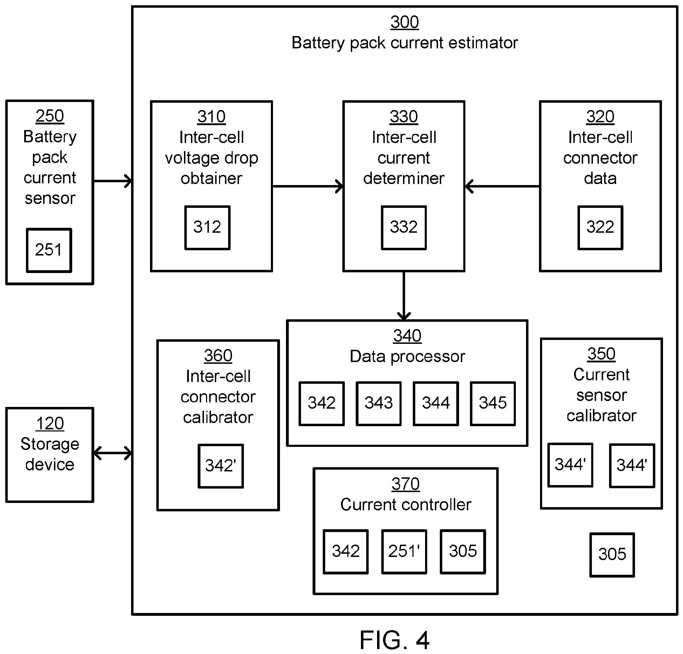

In **FIG. 4****,** a system diagram of a battery pack current estimator **300** is shown. The battery pack current estimator **300** is configured to estimate a battery pack current estimate **305.** The battery pack current estimate **305** is an estimate of a current provided or received by one or more battery packs **200** associated with the battery pack current estimator **300.** The functions of the battery pack current estimator **300** are advantageously performed by the processing circuitry **110** of the computer system **100** and/or the battery pack processing circuitry **210.** It should be mentioned that it may be advantageous to distribute monitoring and supervision of battery cells **210a, 210b, 210c, 210d** between dedicated cell supervision circuits, e.g. analogue front end (AFE) circuits, arranged proximal to their associated battery cells **210a, 210b, 210c, 210d.** Such dedicated cell supervision circuits are considered to form part of the battery pack processing circuitry **210.** The battery pack current estimator **300** is advantageously configured to receive and/or provide data to the storage device **120** and/or the battery pack current sensor **250.**

The battery pack current estimator **300** comprises an inter-cell voltage drop obtainer **310.** The inter-cell voltage drop obtainer **310** is configured to obtain voltage drops **312** across a plurality of inter-cell connectors **230.** An inter-cell voltage drop **312** is a difference in voltage potential between a first connection point and a second connection point interconnected by one or more inter-cell connectors **230.** The inter-cell voltage drops **312,** or voltage drops **312** for short, may be obtained by the previously introduced battery pack sensor circuitry **240.** An inter-cell voltage drop **312** may be described as associated with the one or more inter-cell connectors **230** across which it is obtained.

In **FIG. 4****,** the battery pack current estimator **300** comprises inter-cell connector data **320.** In other examples, the battery pack current estimator **300** may be configured to obtain the inter-cell connector data **320** from the storage device **120.** In some examples, some inter-cell connecter data **320** is comprised in the battery pack current estimator **300,** and some inter-cell connecter data **320** is stored in the storage device **120.** The inter-cell connector data **320** comprises data describing the inter-cell connectors **230.** The inter-cell connector data **320** comprises resistance data **322** associated with at least two of the inter-cell connectors **230** of the battery pack **200.** The resistance data **322** comprises a resistance value describing an electrical resistance of a plurality of inter-cell connectors **230** of the battery pack **200.** The resistance data **322** may comprise a reactance value describing an electrical reactance of a plurality of inter-cell connector **230** of the battery pack **200.** The resistance data **322** may be provided as a function of temperature, or compensated based on a temperature of the associated inter-cell connector **230.** The inter-cell connector data **320** may describe how the inter-cell connectors **230** of the battery pack **200** are connected. The inter-cell connector data **320** may describe a type of a plurality of inter-cell connectors **230** of the battery pack **200.** The inter-cell connector data **320** may describe physical characteristics (length, width, current handling capabilities etc.) of a plurality of inter-cell connectors **230** of the battery pack **200.**

The battery pack current estimator **300** further comprises an inter-cell current determiner **330.** The inter-cell current determiner **330** is configured to determine a plurality of inter-cell currents **332.** Each inter-cell current **332** is determined based on an inter-cell voltage drop **312** of a specific inter-cell connector **230** (or plurality of specific inter-cell connectors **230)** together with resistance data **322** of the specific inter-cell connector **230** (or plurality of specific inter-cell connectors **230).** The inter-cell currents **332** are advantageously determined using Ohm's law.

The battery pack current estimator **300** further comprises a data processor **340.** The data processor **340** is configured to process the plurality of inter-cell current **332** and determine the battery pack current estimate **305.** The data processor **340** may be configured to determine the battery pack current estimate **305** in any suitable way. In one example, the data processor **340** is configured to determine an inter-cell current average **342** of the plurality of inter-cell current **332.** The battery pack current estimate **305** may determined by setting the battery pack current estimate **305** to the inter-cell current average **342,** or by basing the battery pack current estimate **305** on the inter-cell current average **342.** In some examples, the inter-cell current average **342** is an arithmetic mean of the plurality of inter-cell current **332.** In some examples, the inter-cell current average **342** is a geometric mean of the plurality of inter-cell current **332.** In some examples, the data processor **340** may be configured to determine an inter-cell current estimate standard deviation **343** of the inter-cell current average **342.** In some examples, the data processor **340** may be configured to determine a delta current indicator **344.** The delta current indicator **344** indicate a difference in current between a battery pack current **251** sensed by the battery pack current sensor **250** and the battery pack current estimate **305.** The delta current indicator **344** may consequently be determined by comparison of the battery pack current **251** to the battery pack current estimate **305.** In some examples, the data processor **340** may be configured to determine a delta current shift **345.** The delta current shift **345** indicate a shift in delta current indicator **344** and may be obtained by comparing a current delta current indicator **344** to one or more previous delta current indicators **344.** Advantageously, the delta current shift **345** is determined by comparison of the current delta current indicator **344** to a sliding delta current indicator average provided as a sliding average of a plurality of previous delta current indicators **344.**

By determining the battery pack current estimate **305** as the mean of a plurality of inter-cell currents **332,** the battery pack current estimates **305** will tend towards a normal distribution, even if the inter-cell currents **332** themselves are not normally distributed. This is known as the central limit theorem. Further to this, by the law of large numbers, the battery pack current estimate **305** converges to the true mean (expected value) of the inter-cell currents **332.** As the skilled person understands, this is under assumption that no common offset in the inter-cell currents **332** and that e.g. AD converters provide sufficient resolution. This means that by combining several different, advantageously independent, measurements of the same true battery pack current, the battery pack current estimate **305** may provide a more accurate measure of the true battery pack current than the battery pack current sensor **250** as the number of inter-cell currents **332** increases.

In **FIG. 4****,** the battery pack current estimator **300** comprises an optional current sensor calibrator **350.** The current sensor calibrator **350** is configured to monitor data of the battery pack current estimator **300** and determine if the battery pack current sensor **250** is functioning correctly. To this end, the current sensor calibrator **350** may be configured to compare the delta current indicator **344** to a permissible error range **344'.** If the delta current indicator **344** is outside the permissible error range **344'** the current sensor calibrator **350** may be configured to determine that the battery pack current sensor **250** is malfunctioning. The permissible error range **344'** may be a constant predetermined range, a range defined by a percentage of a current delta current indicator **344** or a combination of the two. Additionally, or alternatively, the current sensor calibrator **350** may be configured to compare the delta current shift **345** to a permissible deviation range **345'.** If the delta current shift **345** is outside the permissible deviation range **345',** the current sensor calibrator **350** may be configured to determine that the battery pack current sensor **250** is malfunctioning. The permissible deviation range **345'** may be a constant predetermined range, a range defined by a percentage of a current delta current shift **345** or a combination of the two. The current sensor calibrator **350** is advantageously configured to send an indication of current sensor malfunction to the computer system **100,** if the current sensor calibrator **350** determines that the battery pack current sensor **250** is malfunctioning. Additionally, or alternatively, the current sensor calibrator **350** may be configured to calibrate, offset, compensate or otherwise control the battery pack current sensor **250** and/or the battery pack current **251** based on the battery pack current estimate **305** and/or any other data from the data processor **340.**

In some examples, battery pack current estimator **300** comprises an inter-cell connector calibrator **360.** the inter-cell connector calibrator **360** may be configured to update resistance data **322** of one or more specific inter-cell connector **230** (or plurality of specific inter-cell connectors **230)** based on their associated inter cell voltage drops **312** and the battery pack current estimate **305.** The resistance data **322** may be updated by setting the resistance data **322** to a resistance value calculated based on the inter cell voltage drop **312** and the battery pack current estimate **305.** In some examples, the resistance data **322** may be updated by weighting the resistance data **322** with the resistance value calculated based on the inter cell voltage drop **312** and the battery pack current estimate **305.** In some examples, the resistance data **322** may be updated by weighting the resistance data **322** with the resistance value calculated based on the inter cell voltage drop **312** and the battery pack current estimate **305.** The weighting may be any suitable weighting, an average etc. Additionally, or alternatively, the inter-cell connector calibrator **360** may be configured to update resistance data **322** correspondingly based on the battery pack current **251.** In order to e.g. reduce noise and filter temporary errors, the battery pack current **251** and/or inter cell voltage drop **312** utilized for updating the resistance data **322** may be an average of a plurality of previous battery pack currents **251** and/or inter cell voltage drops **312,** i.e. time series data of inter-cell voltage drops **312** and/or battery pack currents **251.** Updating of the resistance data **322** is advantageous as it allows the resistance data **322** to be updated and corrected in case of e.g. ageing, damages, etc. of the associated inter-cell connector **230.**

Additionally, or alternatively, the inter-cell connector calibrator **360** may be configured to compare the inter-cell current average **342** to a confidence interval **342'** of the inter cell current average **342.** The confidence interval **342'** may be a predefined confidence interval defined as e.g. a percentage, and/or the confidence interval **342'** may be defined based on the standard deviation **343** of the inter-cell current average **342.** In some examples, the confidence interval **342'** may be defined as the standard deviation **343** plus/minus four times the standard deviation **343** of the inter-cell current average **342.** In some examples, the confidence interval **342'** may be defined as the standard deviation **343** plus/minus five times the standard deviation **343** of the inter-cell current average **342.** In some examples, the confidence interval **342'** may be defined as the standard deviation **343** plus/minus six times the standard deviation **343** of the inter-cell current average **342.** The inter-cell connector calibrator **360** may be configured to determine that any inter cell connectors **230** exhibiting an inter-cell current **332** being outside the confidence interval **342'** of the inter-cell current average **342** are malfunctioning. Advantageously, the inter-cell connector calibrator **360** is configured to send an indication of inter-cell connection malfunction to the computer system **100,** if the current sensor calibrator **350** determines that one or more inter-cell connectors **230** are malfunctioning.

Additionally, or alternatively, the inter-cell connector calibrator **360** may be configured to identify inter-cell connector **230** determined to be malfunctioning and the inter cell current determiner **330** may be configured to exclude inter-cell voltages **312** associated with the malfunctioning inter-cell connectors **230** from consecutive estimations of battery back current estimate **305.**

In some examples, battery pack current estimator **300** comprises a current controller **370.** The current controller **370** may be configured to determine if power (current) should be transfer to from the battery pack **200** at any given point in time. Generally, a battery pack **200** prevent further power going into or being provided by the battery pack **200** if the battery back current **251** was outside an permissible battery current range **251'.** However, in the battery pack current estimator **300** of the present disclosure, the current controller **370** may be configured to permit further transfer of power to/from the battery pack **200** even if the battery pack current **251** sensed by the current sensor **250** is outside the permissible battery current range **251'.** In one example, the current controller **370** is configured to prevent further power transfer to/from the battery pack **200** if both the battery pack current estimate **305** and the battery pack current **251** are outside the battery current range **251'.** That is to say, the current controller **370** may be configured to permit further power transfer to/from the battery pack **200** if the battery pack current estimate **305** is inside the battery pack current range **251'** and the battery pack current **251** is outside the battery current range **251'.** In some examples, the current controller **370** may be configured to permit further power transfer to/from the battery pack **200** if the battery pack current estimate **305** is outside the battery pack current range **251'** and the battery pack current **251** is inside the battery current range **251'.** In some examples, the current controller **370** may be configured to permit further power transfer to/from the battery pack **200** if the current sensor **250** is determined to be malfunctioning. In some examples, the current controller **370** may be configured to permit further power transfer to/from the battery pack **200** if the battery pack current estimate **305** is inside the battery pack current range **251'** and the current sensor **250** is determined to be malfunctioning. In some examples, the current controller **370** may be configured to permit further power transfer to/from the battery pack **200** at a limited rate if the current sensor **250** is determined to be malfunctioning.

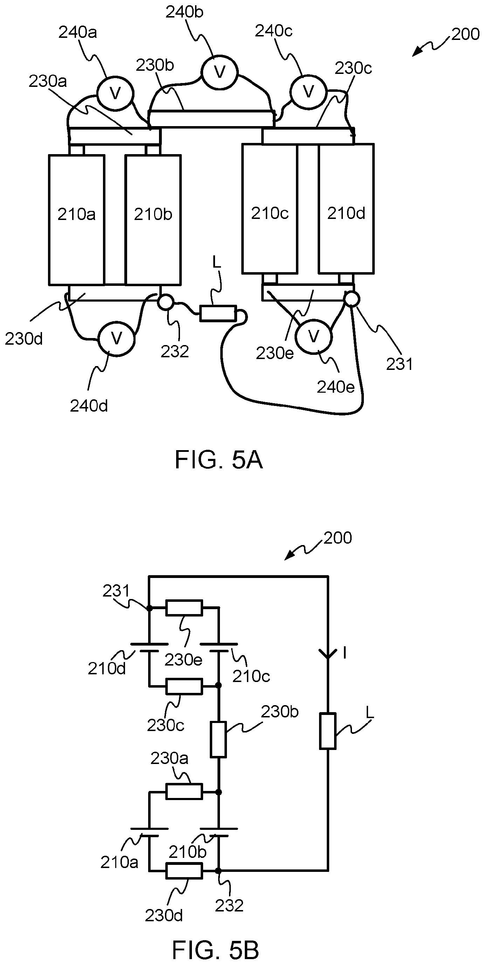

It should be mentioned that the functionality presented herein will allow a statistically accurate measure of a true current provided by or received by a battery pack **200.** A risk of unwanted downtime due to inaccurate current measurements is reduced. It is not uncommon for a battery pack **200** suitable for a vehicle **10** to comprise more than 5000 battery cells **210,** and well over 9000 battery cells **210** is also commonplace. Each of these cells are connected by a respective inter-cell connector **230** making their associated set of inter-cell voltages **312** well within the range of what may be considered a normal distribution. A group of battery cells **210** is generally connected in parallel (by inter-cell connectors **230)** to form what may be referred to as a logical cell. A plurality of logical cells are generally connected in series (by inter-cell connectors **230)** and generally voltages between each of these logic cells is monitored by e.g. the battery pack processing circuitry **220.** A vehicle **10** generally comprise 100-200 logical cells with inter-cell connectors **230** which also provide a sufficiently large sample size for assuming their averages being normally distributed. As mentioned earlier, generally, not all battery cells **210** are placed in parallel, but generally sets of battery cells **210** are arranged in parallel to obtain a wanted capacitance of the battery pack **200** and these sets are arranged in series to obtain a wanted voltage of the battery pack **200.** This will be detailed with a simplified example in **FIG. 5A** and **FIG. 5B****.**

In **FIG. 5A****,** an exemplary schematic view of a partial battery pack **200** is shown. In **FIG. 5A****,** the battery pack **200** comprises a first battery cell **210a,** a second battery cell **210b,** a third battery cell **210c** and a fourth battery cell **210d.** The first battery cell **210a** and the second battery cell **210b** are connected in parallel by a first inter-cell connector **230a** and a fourth inter-cell connector **230d.** The third battery cell **210c** and the fourth battery cell **210d** are connected in parallel by a third inter-cell connector **230c** and a fifth inter-cell connector **230e.** The parallel arrangement of the first battery cell **210a** and the second battery cell **210b** is connected in series with the parallel arrangement of the third battery cell **210c** and the fourth battery cell **210d** by a second inter-cell connector **230b.** The first connector **231** is operatively connector to the fifth inter-cell connector **230e.** The second connector **232** is operatively connector to the fourth inter-cell connector **230d.** An exemplary load **L** is connected between the first connector **231** and the second connector **232.** In **FIG. 5A****,** a plurality of sensor circuits **240a, 240b, 240c, 240d, 240e** are provided to sense inter-cell voltage drops **312** of their respective inter-cell connector **230a, 230b, 230c, 230d, 230e.** In **FIG. 5A****,** a first sensor circuit **240a** is arranged to sense an inter-cell voltage drop across the first inter-cell connector **230a,** a second sensor circuit **240b** is arranged to sense an inter-cell voltage drop across the second inter-cell connector **230b,** a third sensor circuit **240c** is arranged to sense an inter-cell voltage drop across the third inter-cell connector **230c,** an inter-cell fourth sensor circuit **240d** is arranged to sense a voltage drop across the fourth inter-cell connector **230d,** and a fifth sensor circuit **240e** is arranged to sense an inter-cell voltage drop across the fifth inter-cell connector **230e.** In some examples, a specific sensor circuit **240a, 240b, 240c, 240d, 240e, 240f** may be configured to selectively sense voltage drops of more than one inter-cell connector **230a, 230b, 230c, 230d, 230e, 230f.** In some examples, a specific sensor circuit **240a, 240b, 240c, 240d, 240e, 240f** may be configured to sense a voltage drop of two or more inter-cell connector **230a, 230b, 230c, 230d, 230e, 230f** in series.

In **FIG. 5B****,** a schematic of the battery pack **200** of **FIG. 5A** is shown. A current **I** is provided from the battery pack **200** to the load **L.** In the following, ideal components are assumed. As the skilled person will appreciate, the current **I** is equal to an inter-cell current **332** through the second inter-cell connector **230b.** The current **I** is also equal to a sum of the inter-cell currents **332** through the third inter-cell connector **230c** and the fifth inter-cell connector **230e.** Further, the current **I** is also equal to a sum of the inter-cell currents **332** through the first inter-cell connector **230a** and the second inter-cell connector **230d.** In other words, the current **I** through the load **L** may be determined by combinations of inter-cell currents **332** and must not be determined directly from a resistance data **322** and inter-cell voltage **312** of a respective inter-cell connector **230.**

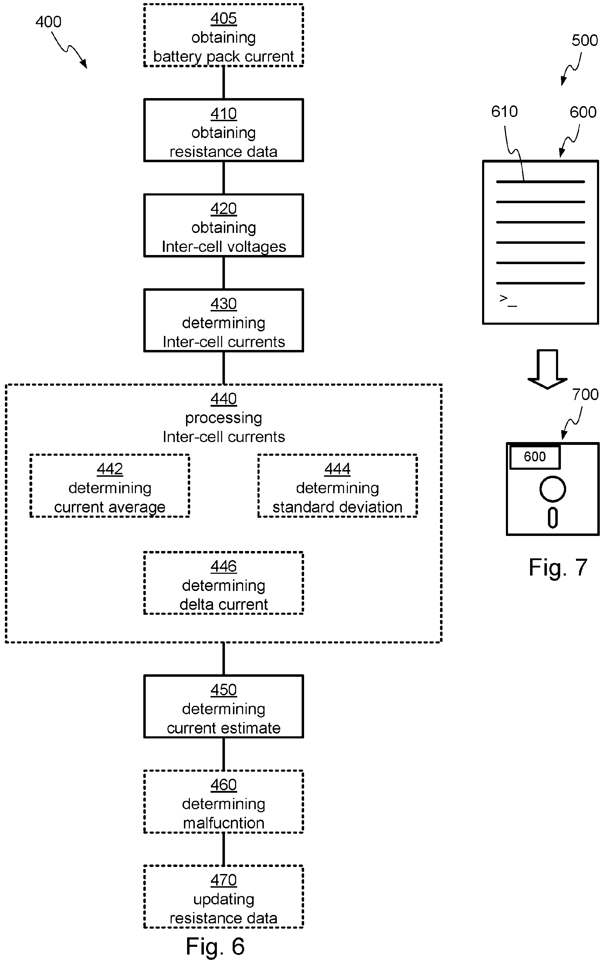

In **FIG. 6****,** a method **400** for providing a current estimate **305** of a our from, or into, a battery pack **200.** The method **400** is advantageously a computer implemented method that may be performed by the computer system **100** presented herein, specifically by processing circuitry **110** of the computer system **100.** In some examples, the processing circuitry **110** of the computer system **100** may be configured to cause execution of the method **400** rather than executing the method **400** itself. The method **400** should not be considered limited to the features presented in reference to **FIG. 6****,** but may advantageously be expanded to comprise any feature, function or example described in the present disclosure, specifically those described in reference to **FIG. 4****.**

The method **400** comprises obtaining **410** resistance data **322** of a plurality of inter-cell connectors **230** of the battery pack **200.** This may comprise, as previously indicated, reading resistance data **322,** or inter-cell connector data **320,** from a storage device **120.** The method **400** further comprises obtaining **420** inter-cell voltage drops **312** across the plurality of inter-cell connectors **230.** This may, as previously described, be achieved by configuring one or more battery pack sensor circuitry **240** to measure, sense or otherwise obtain the inter-cell voltage drops **312.** The method **400** further comprises determining **430** inter-cell currents **332** based on the resistance data **322** and associated inter-cell voltage drops **312.** This may, as previously described, be achieved by calculation using Ohm's law. The method **400** further comprises determining **450** the battery pack current estimate **305** an estimate of the battery pack current **251** based on the inter-cell currents **332.** This may be achieved by e.g. setting the estimate of the pack currents **305** to one of the inter-cell currents **332.**

Optionally, in some examples, the method **400** may comprise processing **440** of the inter-cell currents **332.** The processing **440** may, as previously indicated, be performed in a number of different ways. In some examples, the processing **440** comprises determining **442** the inter-cell current average **342** of the inter-cell currents **332.** The inter-cell current average **342** may, as previously described, be e.g. an arithmetic mean, a geometric mean etc. The processing **440** may further comprise determining **444** the inter-cell current estimate standard deviation **343** of the inter-cell current average **342.** Additionally, or alternatively, the processing **440** may comprise determining **446** the delta current indicator **344.** The delta current indicator **344** is advantageously determined by comparison of the battery pack current **251** and the battery pack current estimate **305.** To this, or any other suitable end, in some examples, the method **400** may comprise obtaining **405** the battery pack current **251,** advantageously from the current sensor **250** of the battery pack **200.** The determining **450** of the current estimate advantageously utilizes one or more of the inter-cell current average **342,** the inter-cell current estimate standard deviation **343** and/or the delta current indicator **344** in determining the battery pack current estimate **305.**

The method may comprise, as previously described, determining **460** that the batter pack current sensor **250** and/or one or more inter-cell connectors **230** are malfunctioning based on e.g. the inter-cell current average **342,** the inter-cell current estimate standard deviation **343** and/or the delta current indicator **344.**

Optionally, in some examples, the method **400** may comprise, as previously described updating **470** the resistance data **322** and/or the inter-cell connector data **320** based on one or more of the inter-cell voltage drops **312,** the inter-cell currents **332,** the inter-cell current average **342,** the inter-cell current estimate standard deviation **343,** the delta current indicator **344,** etc. Correspondingly, the method **400** may comprise calibrating (not shown), the battery pack current sensor **250** based on one or more of the inter-cell voltage drops **312,** the inter-cell currents **332,** the inter-cell current average **342,** the inter-cell current estimate standard deviation **343,** the delta current indicator **344,** etc.

In **FIG. 7** a computer program product **500** is shown. The computer program product **500** comprises a computer program **600** and a non-transitory computer readable medium **700.** The computer program **600** is advantageously stored on the computer readable medium **700.** The computer readable medium **700** is, in **FIG. 7****,** exemplified as a vintage 5,25" floppy disc, but may be embodied as any suitable non-transitory computer readable medium such as, but not limited to, hard disk drives (HDDs), solid-state drives (SSDs), optical discs (e.g., CD-ROM, DVD-ROM, CD-RW, DVD-RW), USB flash drives, magnetic tapes, memory cards, Read-Only Memories (ROM), network-attached storage (NAS), cloud storage etc.

The computer program **600** comprises instruction **610** e.g. program instruction, software code, that, when executed by processing circuitry cause the processing circuitry to perform the method **400** described herein with reference to **FIG. 6****.**

It should be mentioned that the teachings of the present disclosure are equally applicable to other loads than propulsion sources, and implementations in other fields than transportation and vehicles. Any system, device or arrangement powered by a battery pack wherein accurate, or redundant, estimates of currents is beneficial, may benefit from the present disclosure. Such system, device or arrangement may reside in the field of industrial applications or marine vessels, such as water crafts, motorboats, work boats, sport vessels, boats, ships, among other vessel types.

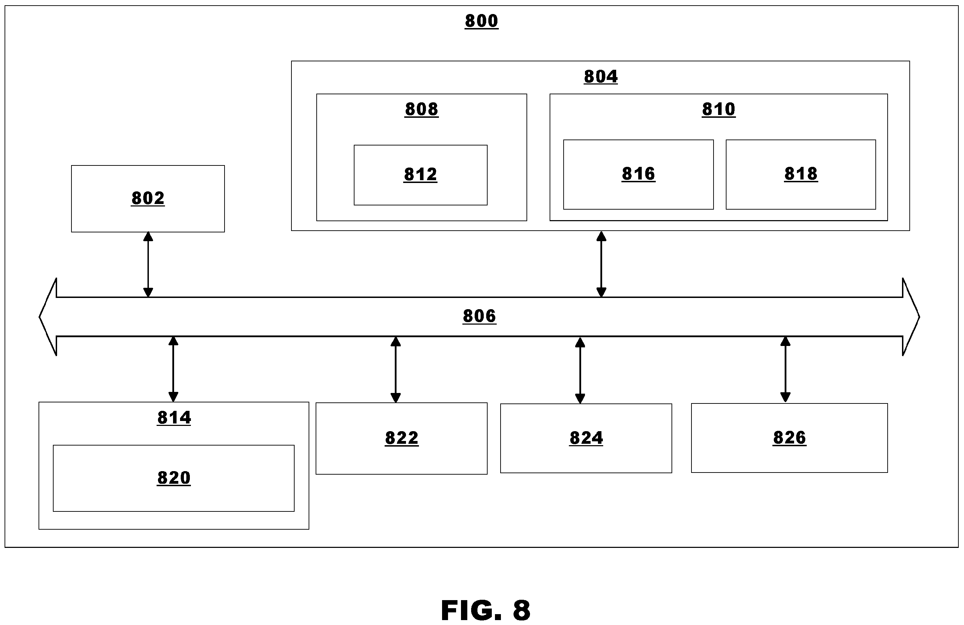

**FIG. 8** is a schematic diagram of a computer system **800** for implementing examples disclosed herein. The computer system **800** may be the computer system **100** introduced with reference to **FIG. 1A****.** The computer system **800** is adapted to execute instructions from a computer-readable medium to perform these and/or any of the functions or processing described herein. The computer system **800** may be connected (e.g., networked) to other machines in a LAN, an intranet, an extranet, or the Internet. While only a single device is illustrated, the computer system **800** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **800** may comprise at least one computing device or electronic device capable of including firmware, hardware, and/or executing software instructions to implement the functionality described herein. The computer system **800** may include processing circuitry **802** (e.g., processing circuitry including one or more processor devices or control units), a memory **804,** and a system bus **806.** The processing circuitry **802** may be, or comprise, the processing circuitry **110** introduced with reference to **FIG. 1B****.** The computer system **800** may include at least one computing device having the processing circuitry **802.** The system bus **806** provides an interface for system components including, but not limited to, the memory **804** and the processing circuitry **802.** The processing circuitry **802** may include any number of hardware components for conducting data or signal processing or for executing computer code stored in memory **804.** The processing circuitry **802** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **802** may further include computer executable code that controls operation of the programmable device.

The system bus **806** may be any of several types of bus structures that may further interconnect to a memory bus (with or without a memory controller), a peripheral bus, and/or a local bus using any of a variety of bus architectures. The memory **804** may be one or more devices for storing data and/or computer code for completing or facilitating methods described herein. The memory **804** may include database components, object code components, script components, or other types of information structure for supporting the various activities herein. Any distributed or local memory device may be utilized with the systems and methods of this description. The memory **804** may be communicably connected to the processing circuitry **802** (e.g., via a circuit or any other wired, wireless, or network connection) and may include computer code for executing one or more processes described herein. The memory **804** may include non-volatile memory **808** (e.g., read-only memory (ROM), erasable programmable read-only memory (EPROM), electrically erasable programmable read-only memory (EEPROM), etc.), and volatile memory **810** (e.g., random-access memory (RAM)), or any other medium which can be used to carry or store desired program code in the form of machine-executable instructions or data structures and which can be accessed by a computer or other machine with processing circuitry **802.** A basic input/output system (BIOS) **812** may be stored in the non-volatile memory **808** and can include the basic routines that help to transfer information between elements within the computer system **800.**

The computer system **800** may further include or be coupled to a non-transitory computer-readable storage medium such as the storage device **814,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **814** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **814** and/or in the volatile memory **810,** which may include an operating system **816** and/or one or more program modules **818.** All or a portion of the examples disclosed herein may be implemented as a computer program **820** stored on a transitory or non-transitory computer-usable or computer-readable storage medium (e.g., single medium or multiple media), such as the storage device **814,** which includes complex programming instructions (e.g., complex computer-readable program code) to cause the processing circuitry **802** to carry out actions described herein. Thus, the computer-readable program code of the computer program **820** can comprise software instructions for implementing the functionality of the examples described herein when executed by the processing circuitry **802.** In some examples, the storage device **814** may be a computer program product (e.g., readable storage medium) storing the computer program **820** thereon, where at least a portion of a computer program **820** may be loadable (e.g., into a processor) for implementing the functionality of the examples described herein when executed by the processing circuitry **802.** The processing circuitry **802** may serve as a controller or control system for the computer system **800** that is to implement the functionality described herein.

The computer system **800** may include an input device interface **822** configured to receive input and selections to be communicated to the computer system **800** when executing instructions, such as from a keyboard, mouse, touch-sensitive surface, etc. Such input devices may be connected to the processing circuitry **802** through the input device
interface **822** coupled to the system bus **806** but can be connected through other interfaces, such as a parallel port, an Institute of Electrical and Electronic Engineers (IEEE) 1394 serial port, a Universal Serial Bus (USB) port, an IR interface, and the like. The computer system **800** may include an output device interface **824** configured to forward output, such as to a display, a video display unit (e.g., a liquid crystal display (LCD) or a cathode ray tube (CRT)). The computer system **800** may include a communications interface **826** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1. A computer system **100** comprising processing circuitry **110** configured to: obtain resistance data **322** of a plurality of inter-cell connectors **230** of a battery pack **200** comprising a plurality of battery cells **210**a, **210**b, **210**c, **210**d, obtain inter-cell voltage drops **312** across the plurality of inter-cell connectors **230,** determine inter-cell currents **332** based on the resistance data **322** and associated inter-cell voltage drops **312,** and determine a battery pack current estimate **305** of a battery pack current **251** of the battery pack **200** based on the inter-cell currents **332.**

Example 2. The computer system **100** of example 1, wherein the processing circuitry **110** is further configured to: determine an inter-cell current average **342** as a mean of the inter-cell currents **332,** and determine the battery pack current estimate **305** based on the inter-cell current average **342.**

Example 3. The computer system **100** of example 2, wherein the processing circuitry **110** is further configured to: determine an inter-cell current estimate standard deviation **343** as a standard deviation of the inter-cell current average **342,** for each inter-cell connector **230** exhibiting an inter-cell current being outside a predefined confidence interval **342'** of the inter-cell current average **342,** determine that the inter-cell connector **230** is malfunctioning.

Example 4. The computer system **100** of example 2 or 3, wherein the processing circuitry **110** is further configured to: determining the average of inter-cell current average **342** as an arithmetic mean of the inter-cell currents **332.**

Example 5. The computer system **100** of example 2 or 3, wherein the processing circuitry **110** is further configured to: determining the inter-cell current average **342** as a geometric mean of the inter-cell currents **332.**

Example 6. The computer system **100** of any one of examples 1 to 5, wherein the processing circuitry **110** is further configured to: obtain, from a battery pack current sensor **250,** a battery pack current **251** of the battery pack **200,** determine a delta current indicator **344** by comparison of the battery pack current **251** and the battery pack current estimate **305,** and responsive to the delta current indicator **344** being outside a permissible error range **344',** determining that the battery pack current sensor **250** is malfunctioning.

Example 7. The computer system **100** of example 6, wherein the processing circuitry **110** is further configured to: determine a delta current shift **345** by comparison of the delta current indicator **344** with one or more previous delta current indicators **344,** and responsive to the delta current shift **345** being outside a permissible deviation range **345',** determining that the battery pack current sensor **250** is malfunctioning.

Example 8. The computer system **100** of example 7, wherein the processing circuitry **110** is further configured to: determine the delta current shift **345** by a comparison of the delta current indicator **344** with a sliding delta current indicator average of a plurality previous delta current indicators **344.**

Example 9. The computer system **100** of any one of examples 6 to 8, wherein the processing circuitry **110** is further configured to: responsive to determining that the battery pack current sensor **250** is malfunctioning, determine that further transfer of power to/from the battery pack **200** is allowed based on the battery pack current estimate **305.**

Example 10. The computer system **100** of any one of examples 1 to 9, wherein the processing circuitry **110** is further configured to: update the resistance data **322** of one or more of the plurality of inter-cell connectors **230** based on the battery pack current estimate **305** and inter-cell voltage drops **312** across the plurality of inter-cell connectors **230,** and/or time series data of inter-cell voltage drops **312** across the plurality of inter-cell connectors **230.**

Example 11. The computer system **100** of any one of examples 6 to 10, wherein the processing circuitry **110** is further configured to: update the resistance data **322** based on the battery pack current **251.**

Example 12. The computer system **100** of any one of examples 3 to 11, wherein the processing circuitry **110** is further configured to: exclude inter-cell currents associated with an inter-cell connector **230** determined to be malfunctioning from determining of a subsequent battery pack current estimate **305.**

Example 13. The computer system **100** of example 1, wherein the processing circuitry **110** is further configured to: determine an inter-cell current average **342** as a mean of the inter-cell currents **332,** and determine the battery pack current estimate **305** based on the inter-cell current average **342;** determine an inter-cell current estimate standard deviation **343** as a standard deviation of the inter-cell current average **342,** for each inter-cell connector **230** exhibiting an inter-cell current being outside a predefined confidence interval **342'** of the inter-cell current average **342,** determine that the inter-cell connector **230** is malfunctioning; determine the average of inter-cell current average **342** as an arithmetic mean of the inter-cell currents **332** or determine the inter-cell current average **342** as a geometric mean of the inter-cell currents **332;** obtain, from a battery pack current sensor **250,** a battery pack current **251** of the battery pack current **251,** determine a delta current indicator **344** by comparison of the battery pack current **251** and the battery pack current estimate **305,** and responsive to the delta current indicator **344** being outside a permissible error range **344',** determining that the battery pack current sensor **250** is malfunctioning; determine a delta current shift **345** by comparison of the delta current indicator **344** with one or more previous delta current indicators **344,** and responsive to the delta current shift **345** being outside a permissible deviation range **345',** determining that the battery pack current sensor **250** is malfunctioning; determine the delta current shift **345** by a comparison of the delta current indicator **344** with a sliding delta current indicator average of a plurality previous delta current indicators **344;** responsive to determining that the battery pack current sensor **250** is malfunctioning, determine that further transfer of power to/from the battery pack **200** is allowed based on the battery pack current estimate **305;** update the resistance data **322** of one or more of the plurality of inter-cell connectors **230** based on the battery pack current estimate **305** and inter-cell voltage drops **312** across the plurality of inter-cell connectors **230,** and/or time series data of inter-cell voltage drops **312** across the plurality of inter-cell connectors **230;** update the resistance data **322** based on the battery pack current **251;** and exclude inter-cell currents associated with an inter-cell connector **230** determined to be malfunctioning from determining of a subsequent battery pack current estimate **305.**

Example 14. A vehicle **10** comprising an electric propulsion source , a battery pack **200** operatively connected to the computer system **100** of any one of examples **1** to **13** and configured to provide power to the electric propulsion source.

Example 15. The vehicle **10** of example **14,** wherein the vehicle **10** is a heavy-duty vehicle **10.**

Example 16. A computer implemented method **400** comprising: obtaining **410,** by a processing circuitry of a computer system **100,** resistance data **322** of a plurality of inter-cell connectors **230** of a battery pack **200** comprising a plurality of battery cells **210**a, **210**b, **210**c, **210**d, obtaining **420,** by the processing circuitry of the computer system **100,** inter-cell voltage drops **312** across the plurality of inter-cell connectors **230,** determining **430,** by the processing circuitry of the computer system **100,** inter-cell currents **332** based on the resistance data **322** and associated inter-cell voltage drops **312,** and determining **450,** by the processing circuitry of the computer system **100,** a battery pack current estimate **305** of a battery pack current **251** of the battery pack **200** based on the inter-cell currents **332.**

Example 17. The computer implemented method **400** of example **16,** further comprising: determining **442,** by the processing circuitry of the computer system **100,** an inter-cell current average **342** as a mean of the inter-cell currents **332,** and determining **450,** by the processing circuitry of the computer system **100,** the battery pack current estimate **305** based on the inter-cell current average **342.**

Example 18. The computer implemented method **400** of example **17,** further comprising: determining **444,** by the processing circuitry of the computer system **100,** an inter-cell current estimate standard deviation **343** as a standard deviation of the inter-cell current average **342,** for each inter-cell connector **230** exhibiting an inter-cell current **332** being outside a predefined confidence interval **342'** of the inter-cell current average **342,** determining, by the processing circuitry of the computer system **100,** that the inter-cell connector **230** is malfunctioning.

Example 19. The computer implemented method **400** of example **18** or **19** further comprising: determining **442,** by the processing circuitry of the computer system **100,** the average of the inter-cell current average **342** as as an arithmetic mean of the inter-cell currents **332.**

Example 20. The computer implemented method **400** of example **17** or **18** further comprising: determining **442,** by the processing circuitry of the computer system **100,** the average of the inter-cell current average **342** as a geometric mean of the inter-cell currents **332.**

Example 21. The computer implemented method **400** of any one of examples **16** to **20** further comprising: obtaining **405,** by the processing circuitry of the computer system **100,** from a battery pack current sensor **250,** a battery pack current **251** of the battery pack current **251,** determining **446,** by the processing circuitry of the computer system **100,** a delta current indicator **344** by comparison of the battery pack current **251** and the battery pack current estimate **305,** and responsive to the delta current indicator **344** being outside a permissible error range **344',** determining **460,** by the processing circuitry of the computer system **100,** that the battery pack current sensor **250** is malfunctioning.

Example 22. The computer implemented method **400** of example **21** further comprising: determining **446,** by the processing circuitry of the computer system **100,** a delta current shift **345** by comparison of the delta current indicator **344** with one or more previous delta current indicators **344,** and responsive to the delta current shift **345** being outside a permissible deviation range **345',** determining **460,** by the processing circuitry of the computer system **100,** that the battery pack current sensor **250** is malfunctioning.

Example 23. The computer implemented method **400** of example **22** further comprising: determining **446,** by the processing circuitry of the computer system **100,** the delta current shift **345** by a comparison of the delta current indicator **344** with a sliding delta current indicator average of a plurality previous delta current indicators **344.**

Example 24. The computer implemented method **400** of any one of examples **21** to **23** further comprising: responsive to determining that the battery pack current sensor **250** is malfunctioning, determining, by the processing circuitry of the computer system **100,** that further transfer of power to/from the battery pack **200** is allowed based on the battery pack current estimate **305.**

Example 25. The computer implemented method **400** of any one of examples **16** to **24** further comprising: updating **470,** by the processing circuitry of the computer system **100,** the resistance data **322** of one or more of the plurality of inter-cell connectors **230** based on the battery pack current estimate **305** and inter-cell voltage drops **312** across the plurality of inter-cell connectors **230,** and/or time series data of inter-cell voltage drops **312** across the plurality of inter-cell connectors **230.**

Example 26. The computer implemented method **400** of any one of examples **16** to **25,** further comprising: updating **470,** by the processing circuitry of the computer system **100,** the resistance data **322** based on the battery pack current **251.**

Example 27. The computer implemented method **400** of any one of examples **16** to **26,** further comprising: excluding, by the processing circuitry of the computer system **100,** inter-cell currents associated with an inter-cell connector **230** determined to be malfunctioning from determining of a subsequent battery pack current estimate **305.**

Example 28. A computer program product comprising program code for performing, when executed by the processing circuitry, the method of any of examples **16** to **27.**

Example 29. A non-transitory computer-readable storage medium comprising instructions, which when executed by the processing circuitry, cause the processing circuitry to perform the method of any of examples **16** to **27.**

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (100) comprising processing circuitry (110) configured to:
obtain resistance data (322) of a plurality of inter-cell connectors (230) of a battery pack (200) comprising a plurality of battery cells (210a, 210b, 210c, 210d),
obtain inter-cell voltage drops (312) across the plurality of inter-cell connectors (230),
determine inter-cell currents (332) based on the resistance data (322) and associated inter-cell voltage drops (312), and
determine a battery pack current estimate (305) of a battery pack current (251) of the battery pack (200) based on the inter-cell currents (332).

2. The computer system (100) of claim 1, wherein the processing circuitry (110) is further configured to:
determine an inter-cell current average (342) as a mean of the inter-cell currents (332), and
determine the battery pack current estimate (305) based on the inter-cell current average (342).

3. The computer system (100) of claim 2, wherein the processing circuitry (110) is further configured to:
determine an inter-cell current estimate standard deviation (343) as a standard deviation of the inter-cell current average (342),
for each inter-cell connector (230) exhibiting an inter-cell current (332) being outside a predefined confidence interval (342') of the inter-cell current average (342), determine that the inter-cell connector (230) is malfunctioning.

4. The computer system (100) of any one of claims 1 to 3, wherein the processing circuitry (110) is further configured to:
obtain, from a battery pack current sensor (250), a battery pack current (251) of the battery pack (200),
determine a delta current indicator (344) by comparison of the battery pack current (251) and the battery pack current estimate (305), and
responsive to the delta current indicator (344) being outside a permissible error range (344'), determining that the battery pack current sensor (250) is malfunctioning; and optionally:
determine a delta current shift (345) by comparison of the delta current indicator (344) with one or more previous delta current indicators (344), and
responsive to the delta current shift (345) being outside a permissible deviation range (345'), determining that the battery pack current sensor (250) is malfunctioning.

5. The computer system (100) of claim 4, wherein the processing circuitry (110) is further configured to:
responsive to determining that the battery pack current sensor (250) is malfunctioning, determine that further transfer of power to/from the battery pack (200) is allowed based on the battery pack current estimate (305).

6. The computer system (100) of any one of claims 1 to 5, wherein the processing circuitry (110) is further configured to:
update the resistance data (322) of one or more of the plurality of inter-cell connectors (230) based on the battery pack current estimate (305) and inter-cell voltage drops (312) across the plurality of inter-cell connectors (230), and/or based on time series data of inter-cell voltage drops (312) across the plurality of inter-cell connectors (230) and/or based on a battery pack current (251) obtained from a battery pack current sensor (250) of the battery pack (200).

7. The computer system (100) of claim 1, wherein the processing circuitry (110) is further configured to: determine an inter-cell current average (342) as a mean of the inter-cell currents (332), and determine the battery pack current estimate (305) based on the inter-cell current average (342); determine an inter-cell current estimate standard deviation (343) as a standard deviation of the inter-cell current average (342), for each inter-cell connector (230) exhibiting an inter-cell current (332) being outside a predefined confidence interval (342') of the inter-cell current average (342), determine that the inter-cell connector (230) is malfunctioning; obtain, from a battery pack current sensor (250), a battery pack current (251) of the battery pack current (251), determine a delta current indicator (344) by comparison of the battery pack current (251) and the battery pack current estimate (305), and responsive to the delta current indicator (344) being outside a permissible error range (344'), determining that the battery pack current sensor (250) is malfunctioning; responsive to determining that the battery pack current sensor (250) is malfunctioning, determine that further transfer of power to/from the battery pack (200) is allowed based on the battery pack current estimate (305); and update the resistance data (322) of one or more of the plurality of inter-cell connectors (230) based on the battery pack current estimate (305) and inter-cell voltage drops (312) across the plurality of inter-cell connectors (230), and/or time series data of inter-cell voltage drops (312) across the plurality of inter-cell connectors (230).

8. A vehicle (10) comprising an electric propulsion source (12), a battery pack (200) operatively connected to the computer system (100) of any one of claims 1 to 7 and configured to provide power to the electric propulsion source (12), preferably, the vehicle (10) is a heavy-duty vehicle (10).

9. A computer implemented method (400) comprising:
obtaining (410), by a processing circuitry of a computer system (100), resistance data (322) of a plurality of inter-cell connectors (230) of a battery pack (200) comprising a plurality of battery cells (210a, 210b, 210c, 210d),
obtaining (420), by the processing circuitry of the computer system (100), inter-cell voltage drops (312) across the plurality of inter-cell connectors (230),
determining (430), by the processing circuitry of the computer system (100), inter-cell currents (332) based on the resistance data (322) and associated inter-cell voltage drops (312), and
determining (450), by the processing circuitry of the computer system (100), a battery pack current estimate (305) of a battery pack current (251) of the battery pack (200) based on the inter-cell currents (332).

10. The computer implemented method (400) of claim 9, further comprising:
determining (442), by the processing circuitry of the computer system (100), an inter-cell current average (342) as a mean of the inter-cell currents (332), and
determining (450), by the processing circuitry of the computer system (100), the battery pack current estimate (305) based on the inter-cell current average (342).

11. The computer implemented method (400) of claim 10, further comprising:
determining (444), by the processing circuitry of the computer system (100), an inter-cell current estimate standard deviation (343) as a standard deviation of the inter-cell current average (342),
for each inter-cell connector (230) exhibiting an inter-cell current (332) being outside a predefined confidence interval (342') of the inter-cell current average (342), determining, by the processing circuitry of the computer system (100), that the inter-cell connector (230) is malfunctioning.

12. The computer implemented method (400) of any one of claims 9 to 11 further comprising:
obtaining (405), by the processing circuitry of the computer system (100), from a battery pack current sensor (250), a battery pack current (251) of the battery pack current (251),
determining (446), by the processing circuitry of the computer system (100), a delta current indicator (344) by comparison of the battery pack current (251) and the battery pack current estimate (305), and
responsive to the delta current indicator (344) being outside a permissible error range (344'), determining (460), by the processing circuitry of the computer system (100), that the battery pack current sensor (250) is malfunctioning;
and optionally:
determining, by the processing circuitry of the computer system (100), a delta current shift (345) by comparison of the delta current indicator (344) with one or more previous delta current indicators (344), and
responsive to the delta current shift (345) being outside a permissible deviation range (345'), determining (460), by the processing circuitry of the computer system (100), that the battery pack current sensor (250) is malfunctioning.

13. The computer implemented method (400) of claim 12 further comprising:
responsive to determining that the battery pack current sensor (250) is malfunctioning, determining, by the processing circuitry of the computer system (100), that further transfer of power to/from the battery pack (200) is allowed based on the battery pack current estimate (305).

14. A computer program product (500) comprising program code (610) for performing, when executed by a processing circuitry (110), the method (400) of any of claims 9 to 13.

15. A non-transitory computer-readable storage medium (700) comprising instructions (610), which when executed by a processing circuitry (110), cause the processing circuitry (110) to perform the method (400) of any of claims 9 to 13.
